# EUROPÄISCHE PATENTSCHRIFT

(11) **EP 0 714 228 B1**
(45) Veröffentlichungstag und Bekanntmachung des Hinweises auf die Patenterteilung: **15.09.1999**
(21) Anmeldenummer: 95118327.6
(22) Anmeldetag: 22.11.1995
(51) Int. Cl.: H05K 5/00

(54) **Zweiteiliges Gehäuse aus Kunststoff zum Aufnehmen einer elektronischen Schaltung**
Plastic casing in two parts for receiving an electronic circuit
Boîtier en deux parties en matière plastique pour loger un circuit électronique

(30) Priorität: 22.11.1994 DE 9418705 U; 20.04.1995 DE 29506698 U
(43) Veröffentlichungstag der Anmeldung: 29.05.1996
(73) Patentinhaber: DODUCO GmbH, 75181 Pforzheim (DE)
(72) Erfinder: Walter,Rüdiger, D-68526 Ladenburg (DE)
(74) Vertreter: Twelmeier, Ulrich, Dipl. Phys.

(56) Entgegenhaltungen:
- DE-A- 3 933 644
- DE-C- 4 142 525
- DE-U- 9 201 258
- US-A- 5 204 498
- IBM TECHNICAL DISCLOSURE BULLETIN, Bd. 33, Nr. 6A, 1.November 1990, ARMONK, NY,USA, Seite 192/193 XP000107681 "CONTENT SELF-CAPTURING/LOCKING ENCLOSURE"

## Beschreibung

Die Erfindung befaßt sich mit einem Gehäuse aus Kunststoff zum Aufnehmen einer elektronischen Schaltung, insbesondere zur Steuerung von Vorgängen in Automobilen, mit einem Gehäuseteil, welches einen Boden und den Boden rahmenförmig umgebende Seitenwände hat, und mit einem Deckel, welcher mit dem Gehäuseteil verrastbar ist. Es ist bekannt, einen Deckel dadurch mit einem Gehäuseteil zu verrasten, daß man die beiden Teile an einem Rand scharnierartig oder durch Zusammenwirken eines Vorsprungs mit einer Vertiefung ineinandergreifen läßt und am gegenüberliegenden Rand eine Rastfeder vorsieht, welche in eine Ausnehmung des anderen Teils fedemd eingreift. Zum Öffnen des Gehäuses kann man mit einer Schraubendreherklinge oder mit einem Messer in die Trennfuge zwischen Gehäuseteil und Deckel eindringen und die Fuge spreizen, wodurch der Rasteingriff gelöst wird. Im Bereich der Automobilelektronik ist es jedoch aus Gründen der Funktionssicherheit und Fahrsicherheit unerwünscht, daß jedermann ein Gehäuse, welches eine elektronische Schaltung enthält, öffnen und an der Schaltung manipulieren kann. Die Gefahr für die Funktionssicherheit und Fahrsicherheit ist in diesem Bereich besonders groß, weil viele Fahrzeugbesitzer versuchen, an ihrem Automobil zu basteln und selbst Fachleute in Automobilwerkstätten nur eingeschränkt in der Lage sind, Arbeiten an elektronischen Schaltungen auszuführen.

Die US-5,204,498 A offenbart bereits ein Gehäuse mit den Merkmalen des Oberbegriffs der Ansprüche 1 und 3. Das Gehäuse besteht aus zwei annähernd gleichen Hälften, von denen jede einen einstückig angespritzten Rasthaken und im Boden eine offene Ausnehmung haben, durch die der Rasthaken des jeweils anderen Gehäuseteils hindurchgreifen und einrasten kann. Bei geschlossenem Gehäuse bleiben die Rasthaken zugänglich, so daß das Gehäuse leicht geöffnet werden kann.

Der vorliegenden Erfindung liegt die Aufgabe zugrunde, ein Gehäuse zu schaffen, welches spritztechnisch einfach herzustellen und nur unter Zerstörung der Verriegelungsmittel für den Deckel geöffnet werden kann, um auf diese Weise unbefugten Eingriffen in die Schaltung ein Hemmnis entgegenzusetzen.

Diese Aufgabe wird gelöst durch ein Gehäuse mit den in den nebengeordneten Ansprüchen 1 und 3 angegebenen Merkmalen. Vorteilhafte Weiterbildungen der Erfindung sind Gegenstand der jeweiligen abhängigen Ansprüche.

Erfindungsgemässe Gehäuse haben Vorteile:
- Dadurch, dass mehrere Rasthaken und dazu passende hinterschnittene Ausnehmungen vorgesehen sind, die verdeckt und damit von aussen unzugänglich angeordnet sind, ist es praktisch nicht möglich, die Rasthaken zugleich durch deren Verbiegen und/oder durch Verbiegen des Gehäuseteils oder des Deckels zu entriegeln und dadurch den Deckel freizugeben.
- Dies wird noch zusätzlich erschwert, wenn in bevorzugter Weiterbildung der Erfindung die Rasthaken am Umfang des Gehäuses verteilt sind, z.B. zwei Stück an jeder Seitenfläche, und wenn die Rasthaken doppelt wirkend ausgebildet sind, indem sie durch einen Längsschlitz zwei Schenkel aufweisen, die jeweils eine hakenförmige Hinterschneidung haben.
- Dadurch, dass die Verrastung von aussen nicht zugänglich ist, besteht auch nicht die Gefahr, dass Rastelemente unabsichtlich abgeschlagen werden.
- Sowohl die Rasthaken als auch die hinterschnittenen Ausnehmungen können unmittelbar in den Spritzgießformen, in denen das Gehäuseteil und der Deckel durch Spritzgießen aus Kunststoff hergestellt werden, geformt werden, ohne dass Nacharbeiten erforderlich wären.

Wenn in der Lösung gemäss dem Anspruch 1 die hinterschnittenen Ausnehmungen sich in den Seitenwänden des Gehäuseteils befinden und die Rasthaken dem Deckel angeformt sind, benötigt der Deckel keine Umfangswand; vielmehr genügt es prinzipiell, dass der Deckel eine Platte ist, von welcher die Rasthaken abstehen. Vorzugsweise ist aber auch in diesem Fall der Deckel mit Seitenwänden versehen, welche ihn rahmenförmig umgeben. Das ist geeignet, die Rasthaken beim Hantieren mit dem Deckel vor Schaden zu schützen, stabilisiert obendrein das Gehäuse und behindert zusätzlich das Eindringen von Feuchtigkeit und anderen Schadstoffen wie Öl und Schmutz.

Bei der Lösung gemäss Anspruch 3 befinden sich die Rasthaken am Gehäuseteil. In diesem Fall benötigt der Deckel Seitenwände, um in diesen die erforderlichen hinterschnittenen Ausnehmungen einbringen zu können. Theoretisch könnte man zwar den Deckel auch ohne Seitenwände so dick machen, dass man die Ausnehmungen darin unterbringen könnte, doch wäre das eine unnötige Materialverschwendung.

Die Federrichtung der Rasthaken könnte quer zu den Seitenwänden orientiert sein. In diesem Fall benötigt man in den Seitenwänden lediglich Ausnehmungen, die zur Innenseite des Gehäuses offen sind. Will man die Seitenwände nicht zu dick machen, können die Ausnehmungen jedoch nicht besonders tief sein und setzen einem Aufbrechen des Gehäuses nicht besonders viel Widerstand entgegen. Bevorzugt ist deshalb eine Ausbildung der Rasthaken in der Weise, dass sie parallel zu den Seitenwänden federn. In diesem Fall sieht man für die Rasthaken Ausnehmungen vor, welche sowohl zur Gehäuseinnenseite als auch zum Rand der Seitenwand hin offen sind, so dass man die Rasthaken beim Aufsetzen des Deckels vom Rand der Seitenwand her in die Ausnehmung einschieben kann. Die Erstreckung der Hinterschnitte an den Rasthaken und entsprechend in den Ausnehmungen kann beträchtlich sein, da sie sich parallel zur Oberfläche der Seitenwand erstrecken und durch die Dicke der Seitenwand nicht begrenzt sind. Es sind deshalb große Rastflächen möglich, die hohe Kräfte zum Aufbrechen des Gehäuses erzwingen.

An dem Gehäuseteil, welches vom Deckel verschlossen wird, können sich die Rasthaken nach Wahl auf der Aussenseite oder auf der Innenseite der Seitenwände befinden. Befinden sie sich auf der Aussenseite, dann muss der Deckel so groß sein, dass er die Seitenwände des Gehäuseteils nach Art einer Kappe umfassen kann. Befinden sich die Rasthaken auf der Innenseite des Gehäuseteils, dann soll der Deckel so ausgebildet sein, dass seine Seitenwände in das andere Gehäuseteil eingeschoben werden können. In beiden Fällen erhält man durch die doppelte Umfangswandung einen sehr stabilen Gehäuseaufbau.

Bevorzugt wegen der leichteren Entformbarkeit ist die Ausbildung, bei welcher sich die Rasthaken auf der Aussenseite der Seitenwände des Gehäuseteils befinden.

Doppelt wirkende Rasthaken sind zwar bevorzugt, aber auch einfach wirkende Rasthaken sind erfindungsgemäss möglich. Einfach wirkende Rasthaken werden allerdings vorzugsweise so angeordnet, dass benachbarte Rasthaken gegensinnig orientierte Hinterschneidungen haben, so dass Scherkräfte, die auf das Gehäuse einwirken, nicht zu einem Lösen der Verrastung führen können.

Ausführungsbeispiele der Erfindung sind in den beigefügten Zeichnungen dargestellt.
- Figur 1: zeigt ein Gehäuseteil eines ersten erfindungsgemässen Gehäuses in einer Schrägansicht,
- Figur 2: zeigt einen zu dem Gehäuseteil aus Figur 1 passenden Deckel,

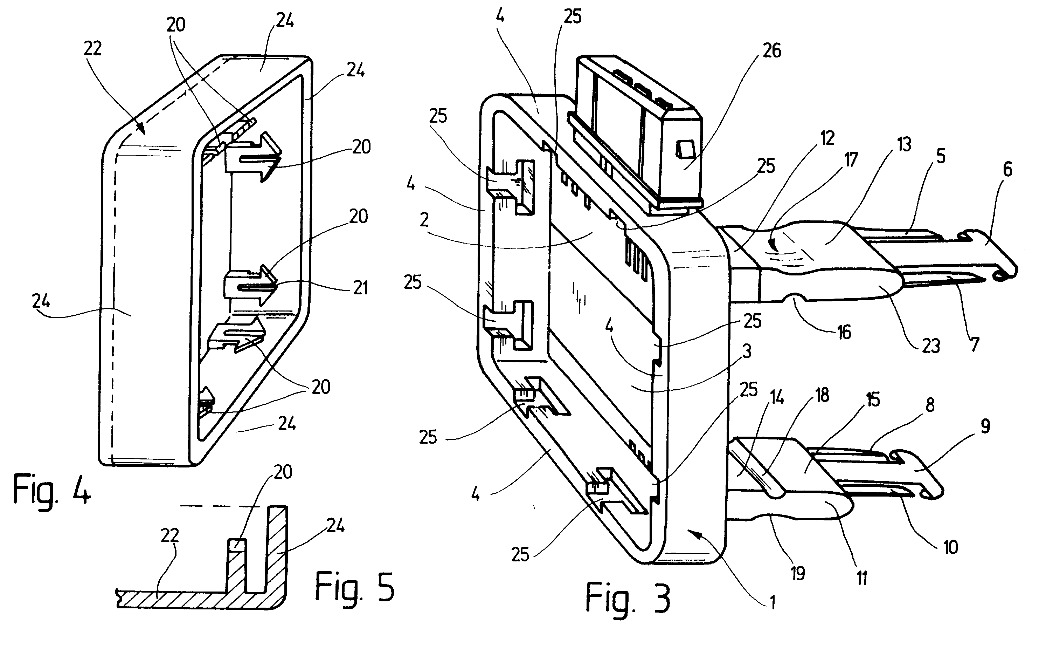

- Figur 3: zeigt ein Gehäuseteil eines zweiten erfindungsgemässen Gehäuses in einer Schrägansicht,
- Figur 4: zeigt einen zu dem Gehäuseteil aus Figur 3 passenden Deckel, und
- Figur 5: zeigt einen Teilschnitt durch den Deckel aus Figur 4 und zwar durch eine Seitenwand und einen Rasthaken gelegt.

Gleiche oder einander entsprechende Teile sind in den beiden Beispielen mit übereinstimmenden Bezugszahlen bezeichnet.

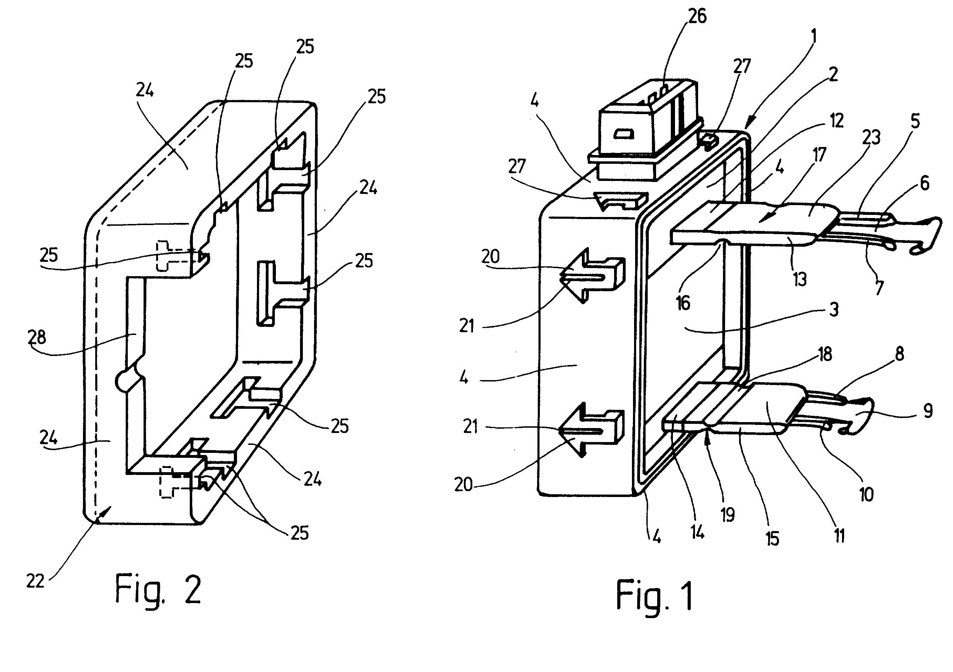

Das in Figur 1 dargestellte Gehäuseteil hat einen im wesentlichen ebenen Boden 2, in welchen eine Metallplatte 3, insbesondere aus Aluminium, eingespritzt ist. Der Boden 2 wird von schmalen Seitenwänden 4 umrahmt, welche in einem Stück mit dem Boden 2 gespritzt werden. Durch den Boden 2 führen zwei Gruppen von je drei Zuleitungen 5, 6 und 7 sowie 8, 9 und 10 hindurch. Die Zuleitungen 5, 6 und 7 haben auf einem Teil ihrer Länge einen gemeinsamen Mantel 23. Die Zuleitungen 8, 9 und 10 haben auf einem Teil ihrer Länge einen gemeinsamen Mantel 11. Der Mantel 23 besteht aus einem ersten Abschnitt 2, welcher auf dem Boden 2 fußt und in einem Arbeitsgang mit dem Gehäuseteil 1 aus einem thermoplastischen Hartkunststoff gespritzt ist. An den ersten Abschnitt 12 schließt sich ein zweiter Abschnitt 13 an, welcher aus einem elastomeren Kunststoff gespritzt ist. Der zweite Abschnitt 13 wird vor dem ersten Abschnitt 12 in einem gesonderten Spritzwerkzeug gespritzt und verbindet sich beim Spritzen des ersten Mantelabschnitts 12 mit diesem fest und innig. Dementsprechend besteht auch der Mantel 11 aus einem ersten, auf der Wand 2 fußenden Abschnitt 14 aus einem thermoplastischen Hartkunststoff und aus einem daran anschließenden zweiten Abschnitt 15 aus einem elastomeren Kunststoff.

Die Zuleitungen 5, 6 und 7 sind durch Stanzen aus einem Metallband, insbesondere aus einem mit Aluminium plattierten Kupferband, gebildet. Dementsprechend sind auch die Zuleitungen 8, 9 und 10 durch Stanzen aus einem Metallband gebildet. Deshalb bilden die drei jeweils gemeinsam ummantelten Zuleitungen 5, 6 und 7 bzw. 8, 9 und 10 ein flaches Gebilde, dessen Mantel z.B. ungefähr rechteckige Umrißlinien hat. Der flache Mantel 23 hat in seinem zweiten Abschnitt 13 auf der dem Mantel 11 zugewandten Seite eine schmale, quer über die gesamte Breite des Mantels verlaufende Rille 16 und auf der gegenüberliegenden Seite eine dazu parallele Schwächung 17, welche weniger steil abfällt als die Rille 16 und deshalb breiter als diese ist. Die Rille 16 und die Schwächung 17 bilden gemeinsam eine Taille, welche das Biegen der ummantelten Zuleitungen 5, 6 und 7 erleichtert; dabei markiert die Rille 16 die Lage der Biegestelle (Sollbiegestelle), wohingegen die Schwächung 17 auf der gegenüberliegenden Seite den Biegevorgang erleichtert. Dementsprechend hat der zweite Mantel 11 in seinem zweiten Abschnitt 15 eine dem ersten Mantel 23 zugewandte Rille 18 als Sollbiegestelle und auf der gegenüberliegenden Seite eine Schwächung 19.

An den vier Seitenflächen 4 des Gehäuseteils 1 befinden sich doppelt wirkende Rasthaken 20, bei welchen durch einen Längsschlitz 21 zwei Schenkel gebildet sind, die gegeneinander federn kcnnen. Diese Rasthaken sind in einem Stück mit dem Gehäuseteil 1 gespritzt. Sie dienen dazu, um das Gehäuseteil mit einem Deckel 22 (Figur 2) zu verrasten, der an der Innenseite seiner vier Seitenwände 24 beim Spritzgießen durch Schieber in der Spritzgießform gebildete T-förmige Ausnehmungen 25 hat, in welche die Rasthaken 20 einführbar sind und dann einrasten. Dieser Rastverschluß kann nur durch Zerstören zumindest eines Teils der Rasthaken geöffnet werden und dient als Sicherung gegen unbefugtes Öffnen des Gehäuses, in welchem sich eine elektrische Schaltung befindet. Eine der Seitenwände 24 des Deckels hat eine Ausnehmung 28, in welche ein dem Gehäuseteil 1 angespritzter Stecker 26 eingreifen kann. Sollte der Platz neben dem Stecker zu knapp sein für zwei doppelt wirkende Rasthaken 20, können dort auch zwei einfach wirkende Rasthaken 27 vorgesehen sein.

Nach dem Herstellen des Gehäuseteils 1 und dem Abbiegen der Zuleitungen 5 bis 7 und 8 bis 10 können an diesen Meßfühler angebracht werden, z.B. ein Temperaturfühler und ein Fühler zum Messen der Luftgeschwindigkeit oder des Luftdurchsatzes.

Das zweite Ausführungsbeispiel unterscheidet sich vom ersten Ausführungsbeispiel darin, dass die Rasthaken 20 nicht auf der Aussenseite der Seitenwände 4 des Gehäuseteils 1 angebracht sind, sondern auf der Deckelplatte stehen, in einigem Abstand von den Seitenwänden 24 des Deckels. Insgesamt sind vier doppelt wirkende Rasthaken am Umfang des Deckels verteilt angeordnet, je zwei vor einer der Seitenwände 24. Das Gehäuseteil 1 hat dafür in den Seitenwänden vier passende, T-förmige Ausnehmungen 25, welche zur Innenseite des Gehäuses und zum Rand der Seitenwände 4 offen sind, wobei die Anordnung so getroffen ist, dass die Rasthaken 20 vom Rand der Seitenwand 4 her in die Ausnehmungen eingeschoben werden können. Zu diesem Zweck ist im zweiten Ausführungsbeispiel der Deckel 22 kleiner als im ersten Ausführuzgsbeispiel, bei gleicher Größe des Gehäuseteils 1.

## Patentansprüche

1. Gehäuse aus Kunststoff zum Aufnehmen einer elektronischen Schaltung, insbesondere zur Steuerung von Vorgängen in Automobilen, mit einem Gehäuseteil (1), welches einen Boden (2) und den Boden (2) rahmenförmig umgebende Seitenwände (4) hat, und mit einem Deckel (22), welcher mit dem Gehäuseteil (1) durch einstückig angespritzte Rasthaken (20), welche in dazu passende, hinterschnittene Ausnehmungen (25) einrasten, verrastbar ist,
**dadurch gekennzeichnet,** daß am Deckel (22) mehrere solche Rasthaken (20) vorgesehen sind, die dem Deckel (22) angespritzt sind, daß die dazu passenden Ausnehmungen (25) an der Innenseite der Seitenwände (4) des Gehäuseteils (1) vorgesehen sind, und daß die Verrastung von außen nicht zugänglich ist.

2. Gehäuse nach Anspruch 1, **dadurch gekennzeichnet,** daß der Deckel (22) Seitenwände (24) hat, die ihn rahmenförmig umgeben und auch die Seitenwände (4) des Gehäuseteils (1) nach Art einer Kappe umgeben.

3. Gehäuse aus Kunststoff zum Aufnehmen einer elektronischen Schaltung, insbesondere zur Steuerung von Vorgängen in Automobilen, mit einem Gehäuseteil (1), welches einen Boden (2) und den Boden (2) rahmenförmig umgebende Seitenwände (4) hat, und mit einem Deckel (22), welcher ebenfalls Seitenwände (24) hat, die ihn rahmenförmig umgeben und mit dem Gehäuseteil (1) durch einstückig angespritzte Rasthaken (20), welche in dazu passende, hinterschnittene Ausnehmungen (25) einrasten, verrastbar ist,
**dadurch gekennzeichnet,** daß die Seitenwände (24) des Deckels (22) in das Gehäuseteil (1) oder die Seitenwände (4) des Gehäuseteils (1) in den Deckel (22) passen, daß die Rasthaken (20) an den einen Seitenwänden (4, 24) und in den ihnen gegenüberliegenden Seitenwänden (24, 4) die hinterschnittenen Ausnehmungen (25) liegen, welche zur gegenüberliegenden Seitenwand (4, 24) offen sind, und daß die Verrastung von außen nicht zugänglich ist.

4. Gehäuse nach Anspruch 3, **dadurch gekennzeichnet,** daß die Rasthaken (20) sich auf der Außenseite der Seitenwände (4) des Gehäuseteils (1) befinden und die Seitenwände (24) des Deckels (22) die Seitenwände (4) des Gehäuseteils (1) nach Art einer Kappe umgeben.

5. Gehäuse nach Anspruch 3, **dadurch gekennzeichnet,** daß die Rasthaken sich auf der Außenseite der Seitenwände des Deckels befinden und die Seitenwände des Gehäuseteils die Seitenwände des Deckels nach Art einer kappe umgeben.

6. Gehäuse nach einen der vorstehenden Ansprüche,
**dadurch gekennzeichnet**, dass die Ausnehmungen (25) nicht nur nach Innen, sondern auch zum Rand der betreffenden Seitenwände (2, 24) hin offen sind.

7. Gehäuse nach einem der vorstehenden Ansprüche,
**dadurch gekennzeichnet**, dass zur Bildung von doppelt wirkenden Rasthaken (20) in den Rasthaken (20) durch einen Längsschlitz (21) zwei Schenkel mit aussen liegender Hinterschneidung gebildet sind.

8. Gehäuse nach einem der Ansprüche 1 bis 6,
**dadurch gekennzeichnet**, dass benachbarte Rasthaken (20, 27) gegensinnig orientierte Hinterschneidungen haben.

9. Gehäuse nach einem der vorstehenden Ansprüche,
**dadurch gekennzeichnet**, dass die Rasthaken (20, 27) und Ausnehmungen (25) am Umfang des Gehäuses verteilt angeordnet sind.

## Claims

1. Plastic casing in two parts for receiving an electronic circuit, especially for controlling processes in motor vehicles, having a casing part (1) comprising a bottom (2) and side walls (4) that enclose the bottom (2) in frame-like fashion, and a cover (22) that can be locked on the casing part (1) by integrally moulded locking hooks (20) that snap into matching undercut recesses (25),
**characterised in that** a plurality of such locking hooks (20) integrally formed on the cover (22) are provided on the cover (22), that the matching recesses (25) are provided on the inside of the side walls (4) of the casing part (1), and that the locking arrangement is not accessible from the outside.

2. The casing as claimed in Claim 1, **characterised in that** the cover (22) comprises side walls (24) that enclose the cover in frame-like fashion and enclose also the side walls (4) of the casing part (1) in cap-like fashion.

3. Plastic casing in two parts for receiving an electronic circuit, especially for controlling processes in motor vehicles, having a casing part (1) comprising a bottom (2) and side walls (4) that enclose the bottom (2) in frame-like fashion, and a cover (22) likewise comprising side walls (24) that enclose it in frame-like fashion and that can be locked on the casing part (1) by integrally moulded locking hooks (20) that snap into matching undercut recesses (25),
**characterised in that** the side walls (24) of the cover (22) fit into the casing part (1) or the side walls (4) of the casing part (1) fit into the cover (22), that the locking hooks (22) are located on one of the side walls (4, 24), respectively, and the undercut recesses (25), which are open toward the opposite side wall (4, 24), are located on the opposite side walls (24, 4) and that the locking mechanism is not accessible.from the outside.

4. The casing as claimed in Claim 3, **characterised in that** the locking hooks (20) are arranged on the outside of the side walls (4) of the casing part (1) and that the side walls (24) of the cover (22) enclose the side walls (4) of the casing part (1) in cap-like fashion.

5. The casing as claimed in Claim 3, **characterised in that** locking hooks are arranged on the outside of the side walls of the cover and that the side walls of the casing part enclose the side walls of the cover in cap-like fashion.

6. The casing as claimed in one of the preceding Claims, **characterised in that** the recesses (25) are open not only toward the inside, but also toward the edge of the respective side wall (2, 24).

7. The casing as claimed in one of the preceding Claims, **characterised in that** for forming double-acting locking hooks (20) two legs with an outward undercut are formed in the locking hooks (20) by a longitudinal slot (21).

8. The casing as claimed in one of Claims 1 to 6, **characterised in that** the undercuts of neighbouring locking hooks (20, 22) are oriented in opposite directions.

9. The casing as claimed in one of the preceding Claims, **characterised in that** the locking hooks (20, 27) and the recesses (25) are distributed over the circumference of the casing.

## Revendications

1. Boîtier en matière plastique destiné à recevoir un montage électronique, en particulier pour la commande de processus dans des automobiles, comprenant une partie de boîtier (1) qui présente un fond (2) et des parois latérales (4) en forme de cadre entourant le fond (2), et comprenant un couvercle (22) pouvant être enclenché avec la partie de boîtier (1) au moyen de crochets d'enclenchement coulés par injection en une seule pièce (20) qui s'enclenchent dans des évidements à contre-dépouille adaptés à cette fin (25), caractérisé en ce que plusieurs crochets d'enclenchement (20) de ce type sont prévus sur le couvercle (22), lesquels sont coulés par injection sur le couvercle (22), en ce que l'enclenchement n'est pas accessible depuis l'extérieur, et en ce que les évidements correspondants (25) sont prévus sur la face intérieure des parois latérales (4) de la partie de boîtier (1).

2. Boîtier suivant la revendication 1, caractérisé en ce que le couvercle (22) possède des parois latérales (24) qui l'entourent en forme de cadre et entourent également les parois latérales (4) de la partie de boîtier (1) à la manière d'un capuchon.

3. Boîtier en matière plastique destiné à recevoir un montage électronique, en particulier pour la commande de processus dans des automobiles, comprenant une partie de boîtier (1) qui présente un fond (2) et des parois latérales (4) en forme de cadre entourant le fond (2), et comprenant un couvercle (22) qui présente également des parois latérales (24) qui l'entourent en forme de cadre et peut être enclenché avec la partie de boîtier (1) au moyen de crochets d'enclenchement coulés par injection en une seule pièce (20) qui s'enclenchent dans des évidements à contre-dépouille correspondants (25), caractérisé en ce que les parois latérales (24) du couvercle (22) s'adaptent dans la partie de boîtier (1), ou les parois latérales (4) de la partie de boîtier (1) dans le couvercle (22), en ce que les crochets d'enclenchement (20) sont agencés sur l'une des parois latérales (4, 24) et les évidements à contre-dépouille (25), qui sont ouverts en direction de la paroi latérale opposée (4, 24), sur la paroi latérale située en opposition à celle-ci (24, 4), et en ce que l'enclenchement n'est pas accessible depuis l'extérieur.

4. Boîtier suivant la revendication 3, caractérisé en ce que les crochets d'enclenchement (20) se trouvent sur la face extérieure des parois latérales (4) de la partie de boîtier (1) et en ce que les parois latérales (24) du couvercle (22) entourent les parois latérales (4) de la partie de boîtier (1) à la manière d'un capuchon.

5. Boîtier suivant la revendication 3, caractérisé en ce que les crochets d'enclenchement se trouvent sur la face extérieure des parois latérales du couvercle et en ce que les parois latérales de la partie de boîtier entourent les parois latérales du couvercle à la manière d'un capuchon.

6. Boîtier suivant l'une quelconque des revendications précédentes, caractérisé en ce que les évidements (25) ne sont pas seulement ouverts en direction de l'intérieur, mais également vers le bord des parois latérales concernées (2, 24).

7. Boîtier suivant l'une quelconque des revendications précédentes, caractérisé en ce que deux montants avec une contre-dépouille située à l'extérieur sont formés dans les crochets d'enclenchement (20) au moyen d'une fente longitudinale (21) en vue de la formation de crochets d'enclenchement (20) à effet double.

8. Boîtier suivant l'une quelconque des revendications 1 à 6, caractérisé en ce que des crochets d'enclenchement adjacents (20, 27) présentent des contre-dépouilles orientées en sens inverse.

9. Boîtier suivant l'une quelconque des revendications précédentes, caractérisé en ce que les crochets d'enclenchement (20, 27) et les évidements (25) sont répartis tout autour de la périphérie du boîtier.
